# EUROPEAN PATENT SPECIFICATION

(11) **EP 0 488 680 B1**
(45) Date of publication and mention of the grant of the patent: **23.04.1997**
(21) Application number: 91310934.4
(22) Date of filing: 27.11.1991
(51) Int. Cl.: H04N 9/80, H04N 5/92, H03H 17/06

(54) **Digital video signal processing apparatus**
Vorrichtung zum Verarbeiten eines digitalen Videosignals
Dispositif de traitement d'un signal vidéo numérique

(30) Priority: 30.11.1990 JP 338349/90
(43) Date of publication of application: 03.06.1992
(73) Proprietor: SONY CORPORATION, Tokyo 141 (JP)
(72) Inventor: Kobayashi, Nobuyoshi, Shinagawa-ku Tokyo (JP); Kominami, Hisanori, Shinagawa-ku Tokyo (JP)
(74) Representative: Cotter, Ivan John

(56) References cited:
- EP-A- 0 196 825
- GB-A- 2 153 618
- US-A- 4 847 684
- CROCHIERE ET AL. 'Multirate Digital Signal Processing' 1986 , PRENTICE-HALL , ENGLEWOOD CLIFFS; US
- PATENT ABSTRACTS OF JAPAN vol. 7, no. 62 (E-164)(1207) 15 March 1983

## Description

This invention relates to digital video signal processing apparatus particularly (but not exclusively) intended for use in digital video tape recorders based on a component format.

As known, in a digital video tape recorder (VTR) of D-1 format (4:2:2 format) (hereinafter referred to as "D-1 VTR") which is designed to produce component video signals comprising a luminance signal Y and colour difference or chrominance signals CB and CR, a system clock frequency fck and signal sampling frequencies fsy, fsb, fsr are set as given below, and the numbers of effective samples (data quantities) Nsy, Nsb, Nsr per line of the individual signals are set to a ratio of 4:2:2 as follows:
fck = 13.5 MHz
fsy = fck fsb = fsr = fck/2
Nsy = 720 Nsb = Nsr = 360

In applying such a D-1 VTR to the wide-screen television systems proposed of late, it has been customary heretofore to prevent geometric distortion of a reproduced image merely by compressing or expanding the time base. However, with mere compression or expansion (extension) of the time base, there arises a problem of deterioration of the resolution of the reproduced image at the ratio Arn/Arw of the standard and wide-angle aspect ratios.

For the purpose of compensating for the deterioration of the resolution, there has been proposed a means of previously setting large numbers of effective samples per line, as disclosed for example in Japanese Patent Application Publication No JP-A-51 018418. According to such means, video signals are sampled alternately by a pair of sampling circuits and are then recorded on a recording medium in a manner to form multiple channels, and subsequently the multichannel sample signals reproduced from the recording medium are combined with each other to produce a wideband signal. However, in the case where the number of effective samples is increased, the quantity of data naturally is also increased, which consequently brings about a problem that proper data processing is not attainable by any of the currently available digital VTRs based on the 4:2:2 format.

In an attempt to solve that data quantity problem, the present applicants have proposed a multichannel digital video signal recording/playback apparatus as disclosed in Japanese Patent Application No 01/339231 (published 29 August 1991 under the publication number JP-A-03 198 595). In this apparatus, high-resolution digital video signals of an 8:4:4 format, where the number of pixels is twice the number in the video signals of a 4:2:2 format, are distributed to two channels alternately per sample in such a manner that the order of distribution is inverted every field, and the video signals are recorded by two digital VTRs of the 4:2:2 format. Thereafter, the signals reproduced by such digital VTRs are combined with each other to obtain the original high-resolution digital video signals, whereby the data quantity in each channel is rendered equal to that of the current 4:2:2 format, thereby realising conversion of the video data into wide-angle data processible by the VTRs of the 4:2:2 format while preventing geometric distortion of the reproduced image and reduction of the resolution.

In distributing and combining the digital video signals in the manner mentioned above it follows that, as seen from the digital VTRs, data rate reduction and interpolation are executed with regard to the respective input and output signals.

Generally, in reducing (curtailing) the rate of the digital video signals to a half, the signal band is limited to be narrower than a half width by a digital low pass filter so as to prevent aliasing. The filter is of a finite impulse response (FIR) type where the coefficients are symmetrical, and has a characteristic such that, in case it is a half-band low pass filter capable of satisfying the first reference of Nyquist, the centre coefficient thereof is 0.5 (to the reference value) while any other coefficients than the centre coefficient become zero alternately.

The characteristic of such a half-band low pass filter can be expressed by the following equation: 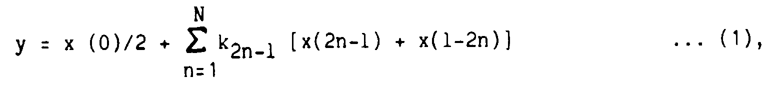 where

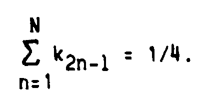

The amplitude characteristic is such that a -6 dB value is obtained at 1/4 of the input signal sampling frequency fs.

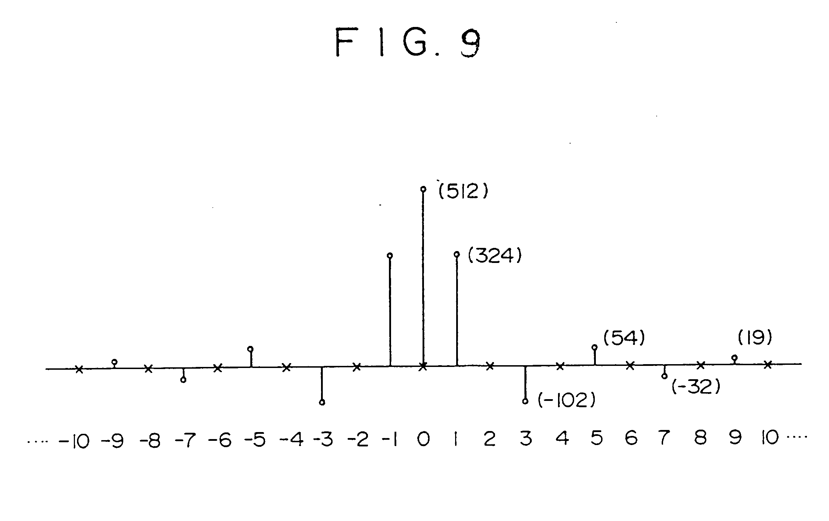

In an exemplary case of 10-bit data, the coefficient distribution (coefficient profile) of the filter is symmetrical with respect to the centre as shown in Figure 9 of the accompanying drawings and in Table 1 below, even coefficients becoming zero alternately with the exception of the centre coefficient k₀.

**TABLE 1**

| | | |
|---|---|---|
| k₀ | (Half reference value) | 512 |
| k₁ | k₋₁ | 324 |
| k₂ | k₋₂ | 0 |
| k₃ | k₋₃ | -102 |
| k₄ | k₋₄ | 0 |
| k₅ | k₋₅ | 54 |
| k₆ | k₋₆ | 0 |
| k₇ | k₋₇ | - 32 |
| k₈ | k₋₈ | 0 |
| k₉ | k₋₉ | 19 |
| k₁₀ | k₋₁₀ | 0 |
| k₁₁ | k₋₁₁ | - 11 |
| k₁₂ | k₋₁₂ | 0 |
| k₁₃ | k₋₁₃ | 6 |
| k₁₄ | k₋₁₄ | 0 |
| l₁₅ | k₋₁₅ | - 3 |
| k₁₆ | k₋₁₆ | 0 |
| k₁₇ | k₋₁₇ | 1 |

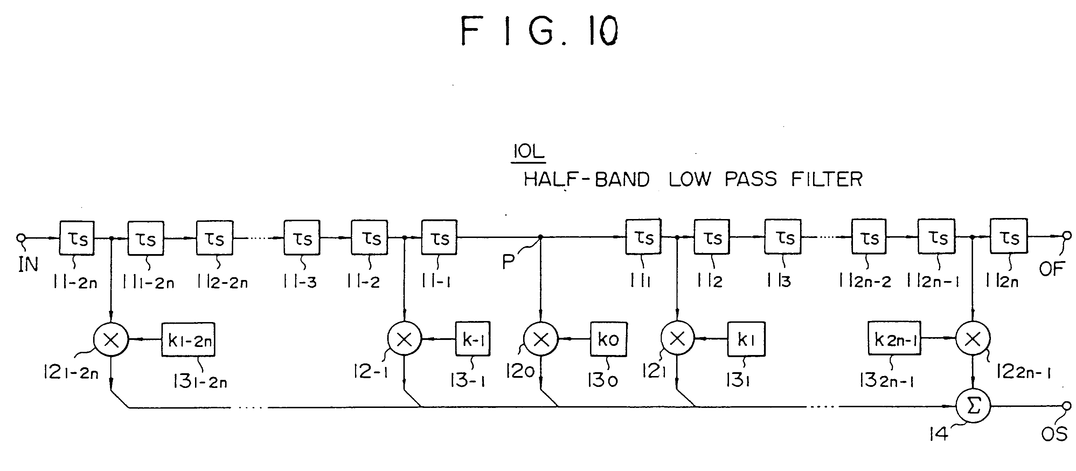

The above half-band low pass filter is generally constructed as shown in Figure 10 of the accompanying drawings.

In the half-band low pass filter 10L of Figure 10, a multiplicity of unitary delay lines (registers) 11₁, 11₂ .... 11₂ₙ; 11₋₁, 11₋₂ .... 11₋₂ₙ, whose delay time τs is equal to the period of the input signal sampling frequency, are connected in series between an input terminal IN and an output terminal OF, their centre point or tap being labelled P. A read only memory (ROM) 13₀ storing therein a centre coefficient k₀ is connected to a multiplier 12₀ which is connected to the point P (centre tap), and multipliers 12₁, 12₃ ... 12₂ₙ₋₁ are connected to the outputs of odd-numbered delay lines 11₁, 11₃ .... 11₂ₙ₋₁ arranged from the point P towards the terminal OF, while the output taps of even-numbered delay lines 11₂ .... 11₂ₙ₋₂ are left unconnected. Multipliers 12₋₁, 12₋₃ .... 12₁₋₂ₙ are connected to the inputs of the odd-numbered delay lines 11₋₁, 11₋₃ .... 11₂ₙ₋₁ sequentially towards the input terminal IN in a manner to be symmetrical to the above with respect to the point P, while the input taps of the even-numbered delay lines 11₂ .... 11₂ₙ₋₂ are left unconnected.

ROMs 13₁, 13₃ ....13₂ₙ₋₁, 13₋₁, 13₋₃ .... 13₁₋₂ₙ storing coefficients therein are connected to the multipliers 12₁, 12₃ .... 12₂ₙ₋₁, 12₋₁, 12₋₃ .... 12₁₋₂ₙ, respectively, and the outputs of all of the multipliers 12 are added to one another in an adder 14 and then are delivered to an output terminal OS.

In producing a pair of chrominance signals of the 4:2:2 format by reducing the rate of the aforementioned video chrominance signals CB, CR of the 8:4:4 format, there is executed, according to a simple concept, a process of limiting the bandwidth for each of the signals CB and CR.

Therefore, two of the above half-band low pass filters are required, which brings about a problem of complicating the construction.

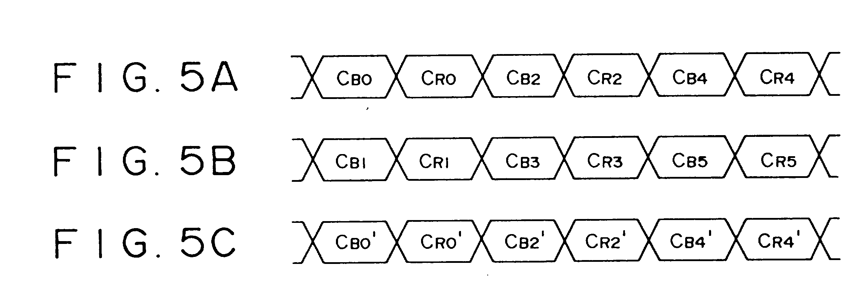

Since chrominance signals of the 8:4:4 format are premised on two-channel distribution as in the above-cited proposal, a pair of signals CB and CR are multiplexed in two channels as shown in Figures 5A and 5B of the accompanying drawings, which will be described later, so that the band limiting process is executed after such signals are demultiplexed, whereby the construction is rendered more complicated.

Besides the above, in producing a pair of chrominance signals of the 8:4:4 format by interpolating chrominance signals CB, CR of the 4:2:2 format, two digital filters are required as in the case of data rate reduction, thereby raising a problem of complicated construction.

In addition, for enabling the two-channel distribution as disclosed in the above-cited proposal, previous multiplexing is needed, consequently complicating the construction.

UK Patent Application Publication GB-A-2 153 618 discloses a digital video processing circuit for halving (or doubling) the data rate of a digital signal. U and V digital video component signals having the same sample rate are switched so as to be alternately supplied to a low pass transversal filter circuit and a delay circuit such that each of these circuits receives U and V samples alternately. An addition means adds outputs of the transversal filter circuit and the delay circuit.

According to the invention there is provided a digital video signal processing apparatus for processing an input signal which has a predetermined data rate and is composed of a pair of time-divided signals derived from a video signal component, the apparatus comprising:
a digital notch filter having a coefficient profile equivalent to that obtained by eliminating delay lines corresponding to a centre coefficient and even-numbered coefficients of a half-band low pass filter, the filter being arranged to be supplied with one of said pair of time-divided signals;
a delay means arranged to be supplied with the other of said pair of time-divided signals and operative to subject it to a predetermined delay corresponding to a delay provided by the digital notch filter; and
an addition means for adding an output of the digital notch filter to an output of the delay means for outputting a signal derived from said video signal component which has a data rate that is lower than said predetermined data rate of said input signal.

Thus, data rate reduction or interpolation of the multiplexed or time-divided signals can be accomplished in an apparatus of relatively simple construction employing merely a single digital filter. That is, there is provided a digital video signal processing apparatus which is capable of performing proper data rate reduction and interpolation of multiplexed signals with a relatively simple construction.

The invention will now be further described, by way of illustrative and non-limiting example, with reference to the accompanying drawings, in which:
Figure 1 is a block diagram of a first digital video signal processing apparatus;
Figure 2 is a block diagram showing the basic construction of a half-band high pass filter of the first apparatus;
Figure 3 is a block diagram showing a specific form of construction of the half-band high pass filter of the first apparatus;
Figure 4 graphically shows the characteristic of the half-band high pass filter of the first apparatus;
Figure 5 schematically shows signals for explaining the operation of the first apparatus;
Figure 6 is a block diagram of a second digital video signal processing apparatus,according to an embodiment of the invention;
Figure 7 is a block diagram showing the basic construction of a digital notch filter of the embodiment;
Figure 8 schematically shows signals for explaining the operation of the embodiment;
Figure 9 graphically shows the characteristic of a half-band low pass filter of a previously proposed digital video signal processing apparatus; and
Figure 10 is a block diagram showing an exemplary construction of the half-band low pass filter of the previously proposed digital video signal processing apparatus.

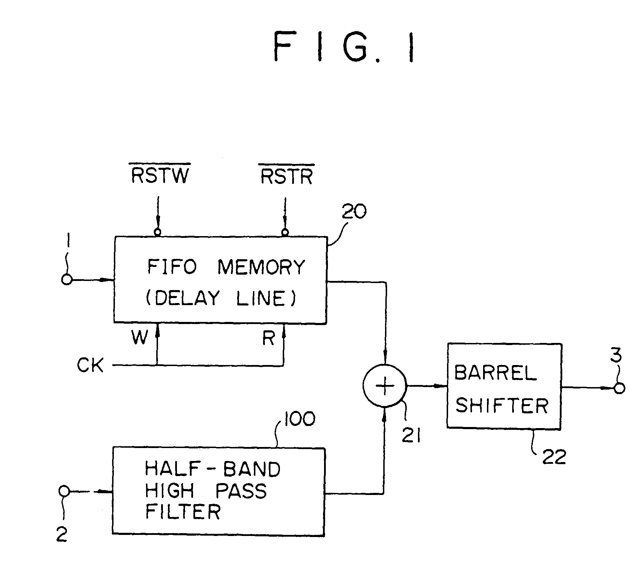

A description will now be given, with reference to Figures 1 to 5, of a first digital video signal processing apparatus which, by way of example, is applied to curtailment of chrominance signals CB, CR based on the 8:4:4 format.

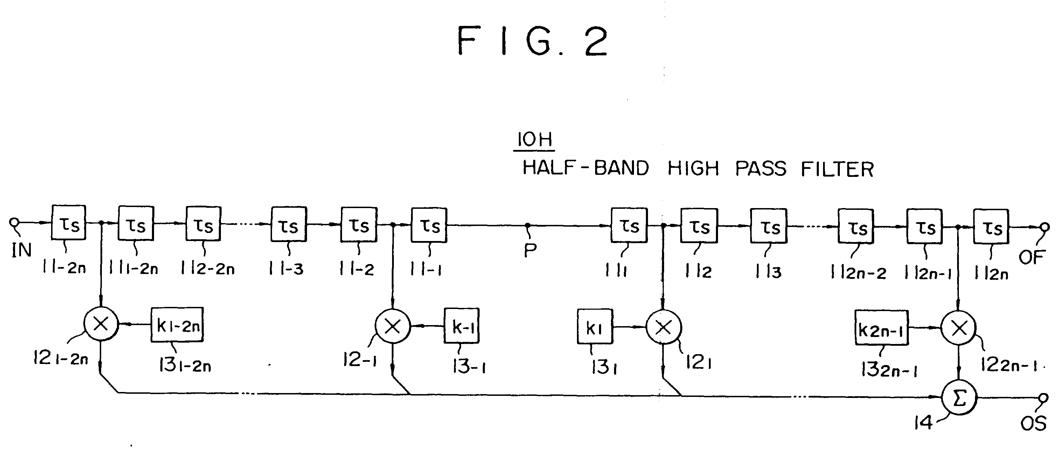

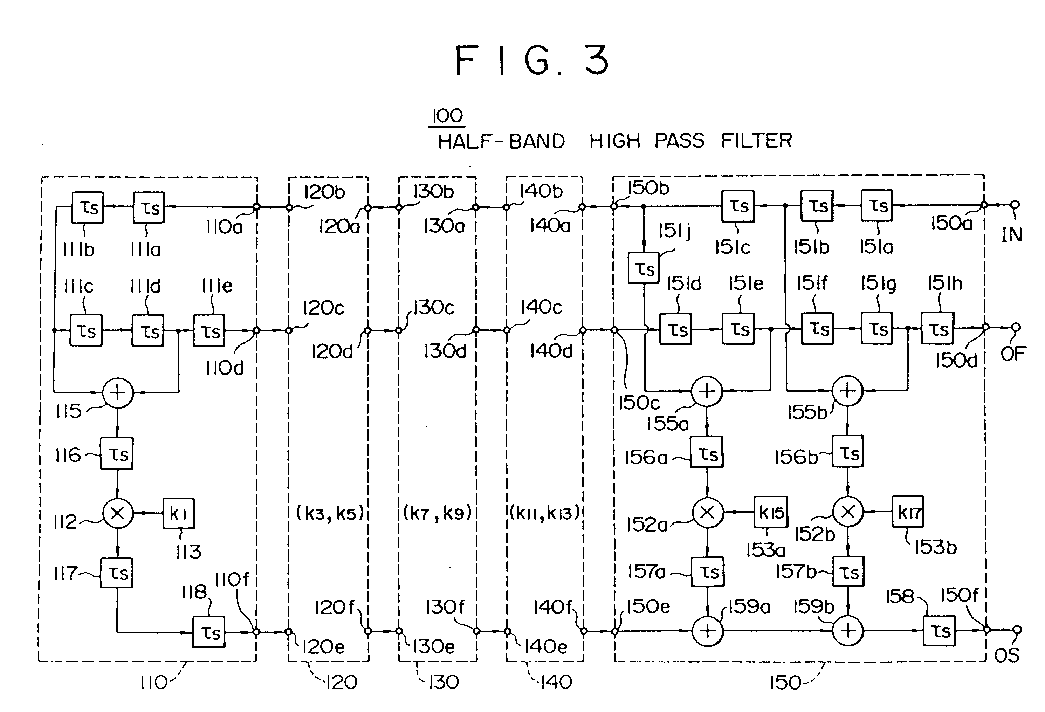

Figure 1 shows the entire apparatus and Figures 2 and 3 respectively show the basic construction and a specific construction of a half-band high pass filter thereof.

The apparatus of Figure 1 includes a first in first out (FIFO) memory 20 and a half-band high pass filter 100. Multiplexed chrominance signals CB, CR of the 8:4:4 format shown in Figures 5A and 5B are supplied from input terminals 1 and 2, respectively. The FIFO memory 20 is supplied as shown with a write/read clock signal and a reset signal and functions as a delay line having a predetermined delay time. Outputs of the FIFO memory 20 and of the half-band high pass filter 100 are supplied to an adder 21, an output of which is delivered to an output terminal 3 via a barrel shifter 22.

Differing from the half-band low pass filter 10L shown in and described above with reference to Figure 9, a basic half-band high pass filter 10H employed in this case is so constructed that, as shown in Figure 2, a tap at a centre point P between an input terminal IN and an output terminal OF is left unconnected. The construction is otherwise exactly the same as in Figure 10.

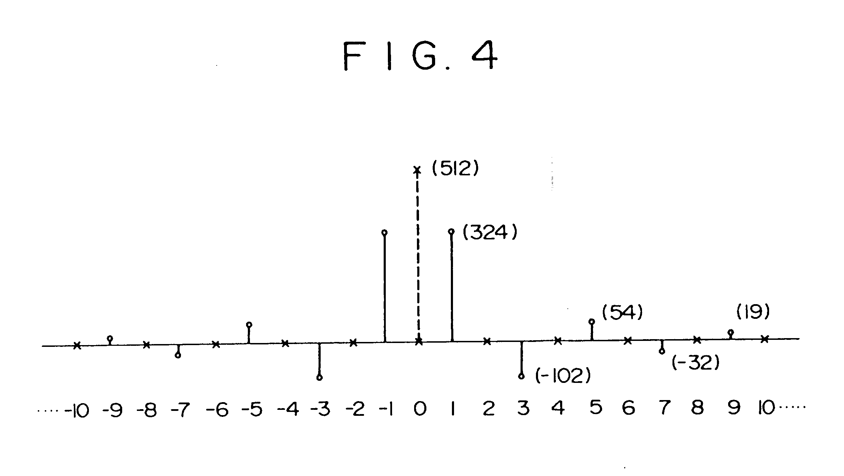

Due to such construction, the coefficient profile of the half-band high pass filter 10H shown in Figure 2 is such that the centre coefficient k₀ is zero and the even coefficients also become zero alternately as shown in Figure 4.

In the basic construction of Figure 2, the coefficient profile of the half-band high pass filter 10H is symmetrical with respect to the centre point P as shown in Figure 4, where coefficients k₁, k₋₁ .... k₁₇, k₋₁₇ of the same value are stored respectively in pairs of ROMS 13₁, 13₋₁, .... 13₂ₙ₋₁, 13₁₋₂ₙ to consequently enlarge the circuit scale.

Therefore, in a practical form of construction thereof shown in Figure 3, the basic half-band high pass filter 10H of Figure 2 is so formed that the coefficient profile is turned back at the centre point P, and the coefficients symmetrical with respect to the centre are stored in respective individual ROMs for reducing the circuit scale.

More specifically, in Figure 3, the half-band high pass filter 100 comprises a unitary circuit (unit) 110 including a single coefficient ROM, and four units 120, 130, 140, 150 having mutually different coefficients and each including two coefficient ROMs.

A first output terminal 150b of the unit 150 is connected to a first input terminal 140a of the unit 140, and second and third output terminals 140d, 140f of the unit 140 are connected respectively to second and third input terminals 150c, 150e of the unit 150. The units 120, 130, 140 are connected in similar manner to that described above such that a first output terminal 120b of the unit 120 is connected to an input terminal 110a of the unit 110, and first and second output terminals 110d, 110f of the unit 110 are connected to second and third input terminals 120c, 120e, respectively, of the unit 120.

In the unit 110, five unitary delay lines 111a to 111e are connected in series between the input terminal 110a and the output terminal 110d. An output of the delay line 111b and an output of the delay line 111d are supplied to a multiplier 112 via an adder 115 and a delay line 116, while an input-side tape of the delay line 111d is left unconnected. A coefficient ROM 113 is connected to the multiplier 112, an output of which is delivered to the second output terminal 110f via delay lines 117 and 118.

The delay lines 111e, 118 connected to the output terminals 110d, 110f, respectively, serve to attain a timing coincidence of the signals.

In the unit 150, which is structurally the same as any of the units 120, 130 and 140, three unitary delay lines 151a to 151c are connected in series between a first input terminal 150a and the first output terminal 150b, and five unitary delay lines 151d to 151h are connected in series between the second input terminal 150c and a second output terminal 150d.

A first adder 155a is supplied with the output of the delay line 151c via a delay line 151j and is supplied with the output of the delay line 151e directly. A second adder 155b is supplied with the outputs of the delay lines 151b, 151g. Input-side taps of the delay lines 151b, 151e, 151g, 151j are left unconnected.

The output of the first adder 155a is supplied via a delay line 156a to a first multiplier 152a where it is multiplied by a coefficient obtained from a first ROM 153a. The output of the multiplier 152a is supplied via a delay line 157a to a third adder 159a. In similar manner, the output of the second adder 155b is supplied via a delay line 156b to a second multiplier 152b where it is multiplied by a coefficient obtained from a second ROM 153b. The output of the multiplier 152b is supplied via a delay line 157b to a fourth adder 159b. The adders 159a, 159b are connected in series between the third input terminal 150e and a third output terminal 150f together with a delay line 158.

The delay lines 151h, 158 connected to the output terminals 150d, 150f serve to attain a timing coincidence of the signals.

The operation of the first digital video signal processing apparatus will now be described with reference to Figures 4 and 5.

In the half-band high pass filter 100 employed in this apparatus, the centre coefficient k₀ is zero as shown in the coefficient profile of Figure 4.

In case the low pass filter 10L described above with reference to Figure 10 is so constructed as to subtract the output signal of the high pass filter from the signal of a main transmission line, setting the centre coefficient k₀ of the half reference value in the low pass filter to zero is equivalent to removal of the main line signal. Therefore, the half-band filter 10H of Figure 2 (and the half-band filter 100 of Figure 3, equivalent thereto) are regarded as high pass filters each having a reverse characteristic to that of the low pass filter 10L of Figure 10.

In this apparatus, an even sample train and an odd sample train of chrominance signals of the 8:4:4 format, where CB and CR shown in Figures 5A and 5B are multiplexed per sample, are supplied to both the FIFO memory 20 and the half-band high pass filter 100.

Such two sample trains are distributed by a comb filter or the like (not shown) separately from the above, and the aliasing components thereof are mutually opposite in phase. Each of the sampling frequencies fse and fso is equal to the clock frequency fck of the 4:2:2 format. Specifically, fse = fso = fck = 13.5 MHz.

The aliasing component of the odd sample train is extracted from the half-band high pass filter 100 and then is supplied to the adder 21, where such component is added to the even sample train compensated by the FIFO memory 20 with regard to the delay time of the filter 100. As mentioned already, the chrominance signal obtained from the FIFO memory 20 is a main line signal equivalent to the centre coefficient k₀ shown in Figure 9. When the main line signal is added to the output of the half-band high pass filter 100 where the centre coefficient is zero, the aliasing components of mutually opposite phase cancel each other, so that the apparatus of Figure 1 functions as a half-band low pass filter.

The band-limited multiplexed even sample train CBO', CRO', CB2', CR2', .... shown in Figure 5C is delivered from the output terminal 3. The sampling frequency fse' of this sample train is also equal to the clock frequency fck of the 4:2:2 format. Specifically, fse' = fck = 13.5 MHz

Thus, in the first apparatus of relatively simple construction employing a single digital filter, it becomes possible to obtain multiplexed chrominance signals CB and CR of the 4:2:2 format with a data rate reduced (curtailed) to 1/2 of the input data rate.

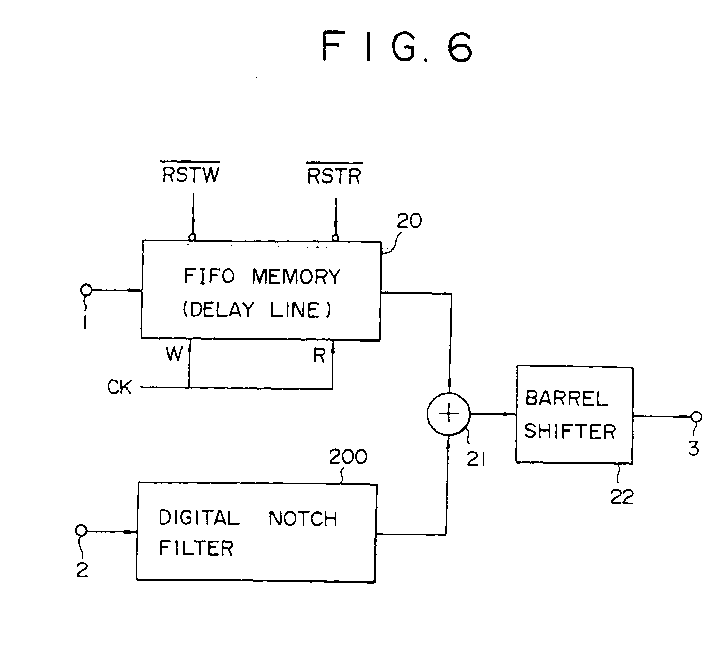

A description will now be given, with reference to Figures 6 to 8, of a second digital video signal processing apparatus, which is an embodiment of the invention, and which, by way of example, is applied to curtailment or reduction of the data rate of a luminance signal based on the 8:4:4 format.

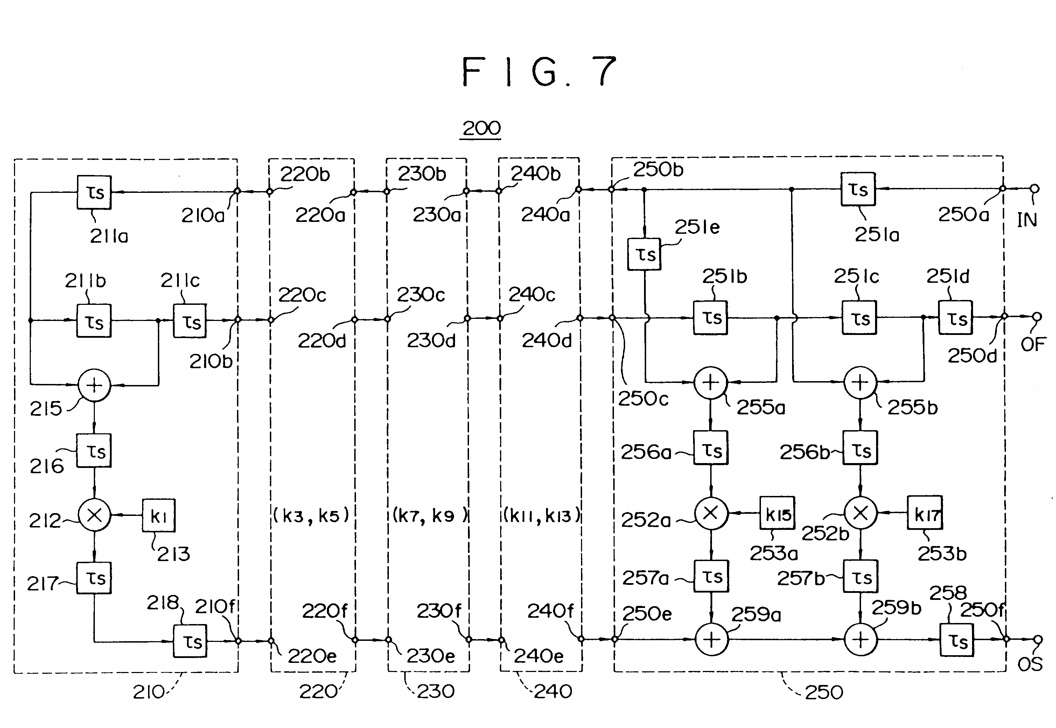

Figure 6 shows the entire apparatus and Figure 7 shows the basic construction of a digital notch filter thereof. In Figure 6, component elements corresponding to those in Figure 1 are designated by the same reference signs and a description of these elements is not repeated in full.

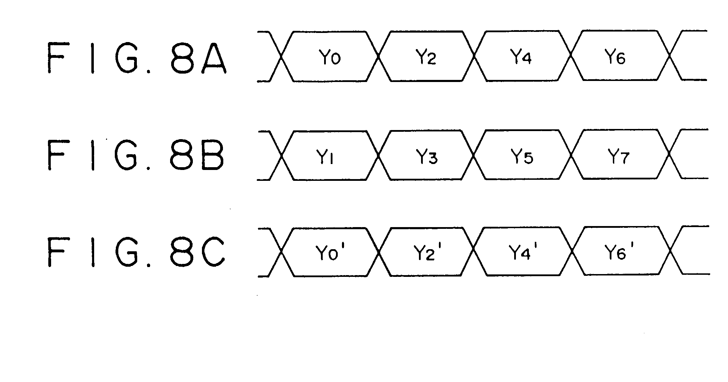

The apparatus of Figure 6 includes an FIFO memory 20 and a digital notch filter 200, wherein luminance signals of the 8:4:4 format shown in Figures 8A and 8B are supplied from a pair of input terminals 1 and 2, respectively. An output of the FIFO memory 20 (functioning as a delay line of a predetermined delay time) and an output of the digital notch filter 200 are supplied to an adder 21, an output of which is delivered to an output terminal 3 via a barrel shifter 22.

Similarly to the half-band high pass filter 100 described above with reference to Figure 3, the digital notch filter 200 comprises, as shown in Figure 7, a unit 210 including one coefficient ROM and four units 220, 230, 240, 250 having mutually different coefficients and each including two coefficient ROMs. The units 210 to 250 are mutually connected in the same manner as the units 110 to 150 in the high pass filter 100 of Figure 3.

In the unit 210, three unitary delay lines 211a to 211c are connected in series between an input terminal 210a and an output terminal 210b, and both the input and output of the delay line 211b are supplied to a multiplier 215. The construction posterior to the adder 215 is the same as that of the unit 110 in the high pass filter 100 of Figure 3. The delay lines 211c, 218 connected to the output terminals 210b, 210f, respectively, serve to attain a timing coincidence of the signals.

In the unit 250, which is structurally the same as any of the units 220, 230 and 240, a unitary delay line 251a is connected between a first input terminal 250a and a first output terminal 250b, and three unitary delay lines 251b to 251d are connected in series between a second input terminal 250c and a second output terminal 250d.

A first adder 255a is supplied with the output of the delay line 251a via a delay line 251e and is supplied with the output of the delay line 251b directly. A second adder 255b is supplied with the outputs of the delay lines 251a, 251c. The construction posterior to the two adders 255a, 255b is the same as that of the unit 150 in the high pass filter 100 of Figure 3. The delay lines 251d, 258 connected to the terminals 250d, 250f, respectively, serve to attain a timing coincidence of the signals.

The operation of the embodiment will now be described with reference to Figure 8.

The notch filter 200 used in the embodiment is formed substantially into an FIR type of filter without any unconnected tap in rows of delay lines, as shown in Figure 7, wherein the coefficients profile thereof is such that all zero points corresponding to the centre and even coefficients of a half-band low pass filter are eliminated from the profile (shown in Figure 4) of the high pass filter 100.

In other words, the embodiment of Figure 6 functions as a half-band low pass filter similarly to the apparatus of Figure 1, but a difference resides in the fact that the coefficients of such half-band low pass filter are divided into a row of odd coefficients and a row of even coefficients, and the filter is composed principally of a FIFO memory (main line) 20 corresponding to the row of odd coefficients and a notch filter 200 corresponding to the row of even coefficients and having an amplitude characteristic which is skew symmetrical with respect to a frequency fs/4.

The composite amplitude characteristic (absolute value) of the filter 200 is such that a zero level (notch) is at the frequency fs/4, and the phase is inverted at the notch as a turnover point.

In the embodiment, as shown in Figures 8A and 8B, an even sample train and an odd sample train of the luminance signal based on the 8:4:4 format are time-divided into two channels and are supplied to the FIFO memory 20 and the notch filter 200, respectively.

In similar manner to the first apparatus, the aliasing components in both sample trains are mutually opposite in phase. Also, each of the sampling frequencies fse and fso thereof is equal to the clock frequency fck of the 4:2:2 format. Specifically fse = fso = fck = 13.5 MHz.

A band-limited even sample train Y0', Y2' .... shown in Figure 9C is delivered from the output terminal 3. The sampling frequency fse' of such sample train is also equal to the clock frequency fck of the 4:2:2 format. Specifically, fse' = fck = 13.5 MHz.

Thus, in the embodiment of relatively simple construction employing a signal digital filter, it becomes possible to obtain, from a luminance signal of the 8:4:4 format time-divided into two channels, a luminance signal of the 4:2:2 format with a data rate reduced or curtailed to 1/2 of the input data rate.

The above embodiment has been described as performing a process of reducing or curtailing the data rate of and interpolating luminance and chrominance signals of the 8:4:4 format. However, it is to be understood that the invention is also applicable to video signals of a 4:4:4 format or a 4 x 4 format.

According to the embodiment of the invention described hereinabove, a digital video signal processing apparatus for curtailing and interpolating digital video signals of a component format comprises a notch filter having a coefficient profile equivalent to that obtained by curtailing the centre and even coefficients of a half-band low pass filter, and a delay line having a predetermined delay time, and achieves the improvement of being capable of performing curtailment and interpolation of multiplexed signals with a relatively simple construction employing a single digital filter.

## Claims

1. A digital video signal processing apparatus for processing an input signal which has a predetermined data rate and is composed of a pair of time-divided signals derived from a video signal component, the apparatus comprising:
a digital notch filter (200) having a coefficient profile equivalent to that obtained by eliminating delay lines corresponding to a centre coefficient and even-numbered coefficients of a half-band low pass filter, the filter (200) being arranged to be supplied with one of said pair of time-divided signals;
a delay means (20) arranged to be supplied with the other of said pair of time-divided signals and operative to subject it to a predetermined delay corresponding to a delay provided by the digital notch filter (200); and
an addition means (21) for adding an output of the digital notch filter (200) to an output of the delay means (20) for outputting a signal derived from said video signal component which has a data rate that is lower than said predetermined data rate of said input signal.

2. Apparatus according to claim 1, comprising a barrel shift means (22) connected to receive said signal outputted by the addition means (21).

3. Apparatus according to claim 1 or claim 2, wherein said digital notch filter (200) comprises a single unitary circuit (210) including one coefficient read only memory (213), and a plurality of unitary circuits (220-250) each including two coefficient read only memories (253a, 253b) in which mutually different coefficients are stored.

4. Apparatus according to claim 1, claim 2 or claim 3, wherein the delay means (20) comprises a first in first out memory.

## Patentansprüche

1. Digitale Videosignal-Verarbeitungsvorrichtung zur Verarbeitung eines Eingangssignales, das eine vorbestimmte Datenrate aufweist und aus einem Paar von Zeitmultiplex-Signalen zusammengesetzt ist, die aus einer Videosignal-Komponente erhalten werden, wobei die Vorrichtung aufweist:
ein digitales Sperrfilter (200) mit einem Koeffizientenprofil gleich dem, das durch Beseitigung von Verzögerungsleitungen entsprechend einem Mittenkoeffizienten und geradzahligen Koeffizienten eines Halbband-Tiefpaßfilters erhalten wird, wobei das Filter (200) so angeordnet ist, daß ihm eines des Paars der Zeitmultiplex-Signale zugeführt wird;
eine Verzögerungseinrichtung (20), zu der das andere des Paars der Zeitmultiplex-Signale gegeben wird, und die es einer vorbestimmten Verzögerung unterzieht, die einer Verzögerung entspricht, die durch das digitale Sperrfilter (200) geschaffen wird; und
eine Additionseinrichtung (21) zum Addieren eines Ausgangssignales des digitalen Sperrfilters (200) zu einem Ausgangssignal der Verzögerungseinrichtung (20), um ein Signal auszugeben, das von der Videosignal-Komponente erhalten wurde, das eine Datenrate aufweist, die niedriger als die vorbestimmte Datenrate des Eingangssignales ist.

2. Vorrichtung nach Anspruch 1,
wobei die Vorrichtung eine Walzen(Barrel)-Verschiebungseinrichtung (22) aufweist, die so geschaltet ist, daß sie das durch die Additionseinrichtung (21) ausgegebene Signal aufnimmt.

3. Vorrichtung nach Anspruch 1 oder 2,
bei der das digitale Sperrfilter (200) eine einzelne Einheitsschaltung (210) mit einem Ein-Koeffizienten-Nurlesespeicher (213) sowie mehrere Einheitsschaltungen (220 bis 250) aufweist, die jeweils Zwei-Koeffizienten-Nurlesespeicher (253a, 253b) aufweisen, in denen jeweils unterschiedliche Koeffizienten gespeichert sind.

4. Vorrichtung nach einem der Ansprüche 1 bis 3,
wobei die Verzögerungseinrichtung (20) einen FIFO-Speicher aufweist.

## Revendications

1. Appareil de traitement de signal vidéo numérique pour traiter un signal d'entrée qui présente un débit de données prédéterminé et qui est constitué par une paire de signaux divisés temporellement dérivés à partir d'une composante de signal vidéo, l'appareil comprenant :
un filtre à encoche numérique (200) présentant un profil de coefficients équivalent à celui obtenu en éliminant des lignes de retard correspondant à un coefficient central et à des coefficients de numéros pairs d'un filtre passe-bas demi-bande, le filtre (200) étant agencé de manière à se voir appliquer l'un de ladite paire de signaux divisés temporellement ;
un moyen de retard (20) agencé pour se voir appliquer l'autre de ladite paire de signaux divisés temporellement et fonctionnant pour le soumettre à un retard prédéterminé correspondant à un retard produit par le filtre à encoche numérique (200) ; et
un moyen d'addition (21) pour additionner une sortie du filtre à encoche numérique (200) à une sortie du moyen de retard (20) pour émettre en sortie un signal dérivé à partir de ladite composante de signal vidéo qui présente un débit de données qui est inférieur audit débit de données prédéterminé dudit signal d'entrée.

2. Appareil selon la revendication 1, comprenant un moyen de décalage en barillet (22) connecté pour recevoir ledit signal émis en sortie par le moyen d'addition (21).

3. Appareil selon la revendication 1 ou 2, dans lequel ledit filtre à encoche numérique (200) comprend un unique circuit unitaire (210) incluant une mémoire morte de coefficients (213) et une pluralité de circuits unitaires (220-250) dont chacun inclut deux mémoires mortes de coefficients (253a, 253b) dans lesquelles des coefficients mutuellement différents sont stockés.

4. Appareil selon la revendication 1, 2 ou 3, dans lequel le moyen de retard (20) comprend une mémoire premier entré-premier sorti.
